# EUROPEAN PATENT APPLICATION

(11) **EP 4 797 329 A1**
(43) Date of publication of application: **26.08.2026**
(21) Application number: 24887451.3
(22) Date of filing: 10.07.2024
(51) Int. Cl.: H01L 23/522

(54) **CHIP AND MANUFACTURING METHOD THEREFOR, AND ELECTRONIC DEVICE**

(30) Priority: 09.11.2023 CN 202311493788
(71) Applicant: HUAWEI TECHNOLOGIES CO., LTD., Shenzhen 518129 (CN)
(72) Inventor: CHANG, Yuan, Shenzhen, Guangdong 518129 (CN); YAO, Yuan, Shenzhen, Guangdong 518129 (CN); SONG, Woeiji, Shenzhen, Guangdong 518129 (CN); XU, Jeffrey Junhao, Shenzhen, Guangdong 518129 (CN)
(74) Representative: Thun, Clemens
(86) International application number: PCT/CN2024/104821
(87) International publication number: WO 2025/097827

(57) **Abstract**

This application provides a chip, a method for manufacturing the chip, and an electronic device. The chip includes a transistor, a metal silicide layer, an etching stop layer, an interlayer dielectric layer, and a plurality of first contact holes. The metal silicide layer is disposed at least on a source and a drain in the transistor, and the first contact hole penetrates the etching stop layer and the interlayer dielectric layer. The chip further includes a barrier layer. The barrier layer is disposed between the metal silicide layer and the etching stop layer, and an etching rate of the etching stop layer is greater than an etching rate of the barrier layer under an etching condition of the etching stop layer. In this way, when the etching stop layer is etched, etching on the barrier layer can be prevented, so that the barrier layer can stop etching, etching on the metal silicide layer is prevented, and the metal silicide layer is protected. Even if the metal silicide layer is thin, the source and the drain in the transistor are not affected, and the source and the drain are protected. This improves a manufacturing yield of the chip.

## Description

### CROSS-REFERENCE TO RELATED APPLICATIONS

This application claims priority to Chinese Patent Application No. 202311493788.X, filed with the China National Intellectual Property Administration on November 9, 2023 and entitled "CHIP, METHOD FOR MANUFACTURING CHIP, AND ELECTRONIC DEVICE", which is incorporated herein by reference in its entirety.

### TECHNICAL FIELD

This application relates to the field of semiconductor technologies, and in particular, to a chip, a method for manufacturing the chip, and an electronic device.

### BACKGROUND

A chip includes a substrate, and a transistor, an etching stop layer, and an interlayer dielectric layer that are sequentially disposed on the substrate. A through contact hole is disposed in the etching stop layer and the interlayer dielectric layer. When a metal is deposited in the contact hole, the metal may be electrically connected to a top gate, a source, and a drain in the transistor, so as to transmit a signal to the top gate, the source, and the drain, thereby implementing a function of the transistor. The source is used as an example. To improve effect of an electrical connection between the metal in the contact hole and the source and reduce contact resistance, a metal silicide layer may be disposed between the source and the etching stop layer. Conductivity of the metal silicide layer is between that of the metal and that of silicon, and the metal silicide layer may be used as a transition layer for contact between the metal and a semiconductor, to help form ohmic contact between the metal and a semiconductor layer, thereby reducing contact resistance.

However, when the contact hole is formed, over-etching may occur, and the metal silicide layer may be etched. When the metal silicide layer is thin, the metal silicide layer may be etched through, and the top gate, the source, and the drain may be affected. As a result, a manufacturing yield of the chip is reduced.

### SUMMARY

This application provides a chip, a method for manufacturing the chip, and an electronic device, to resolve a problem that when a metal silicide layer is thin, the metal silicide layer may be etched through, and an electrode in a transistor may be affected, thereby improving a manufacturing yield of the chip.

According to a first aspect, an embodiment of this application provides a chip. The chip may include a transistor, a metal silicide layer, an etching stop layer, an interlayer dielectric layer, and a plurality of first contact holes that are sequentially stacked, where the transistor includes a source and a drain, the metal silicide layer is disposed at least on the source and the drain, and the first contact hole penetrates the etching stop layer and the interlayer dielectric layer. The source overlaps with an orthographic projection that is of at least one first contact hole in the plurality of first contact holes and that is on a substrate, that is, the source overlaps with an orthographic projection that is of a part of the first contact holes and that is on the substrate. The drain overlaps with an orthographic projection that is of at least one first contact hole in the plurality of first contact holes and that is on the substrate, that is, the drain overlaps with an orthographic projection that is of a part of the first contact holes and that is on the substrate. The chip further includes a barrier layer, the barrier layer is disposed between the metal silicide layer and the etching stop layer, and an etching rate of the etching stop layer is greater than an etching rate of the barrier layer under an etching condition of the etching stop layer. In this way, when the first contact hole is formed, because the etching rate of the etching stop layer is greater than the etching rate of the barrier layer under the etching condition of the etching stop layer, etching on the barrier layer can be prevented when the etching stop layer is etched. In addition, a higher etch selectivity ratio of the etching stop layer to the barrier layer indicates a lower probability of etching the barrier layer, so that the barrier layer can stop etching, etching on the metal silicide layer can be prevented, and the metal silicide layer can be protected. Even if the metal silicide layer is thin, the source and the drain in the transistor are not affected, and the source and the drain are protected. This improves a manufacturing yield of the chip.

Optionally, a manner of disposing the barrier layer may include:
In a first manner, the barrier layer is made of a conductive material, so that the manufactured barrier layer is a barrier layer. In addition, the barrier layer is exposed in the first contact hole, so that the exposed barrier layer can be considered as a hole bottom of the first contact hole. In this way, when a conductive layer is deposited in the first contact hole and the metal silicide layer is conductive, the conductive layer may be electrically connected to the source and the drain through the barrier layer and the metal silicide layer, so as to transmit a signal to the source and the drain, thereby helping implement a function of a transistor. A material for manufacturing the barrier layer includes at least one of the following: a metal, a conductive metal oxide, and a conductive polymer material. For example, the metal may be but is not limited to a conductive pure metal, or a conductive metal alloy, or a combination of a conductive pure metal and a conductive metal alloy; the conductive metal oxide may be but is not limited to an indium tin oxide; and the conductive polymer material may be but is not limited to doped polyacetylene. As long as the barrier layer can be obtained, a specific manufacturing material is not specifically limited herein.

In a second manner, the barrier layer is made of a non-conductive material, so that the manufactured barrier layer is a barrier layer. In this case, a second contact hole corresponding to each first contact hole is disposed in the barrier layer, the second contact hole penetrates the barrier layer, and the second contact hole communicates with the corresponding first contact hole. The metal silicide layer may be exposed in the second contact hole, so that the exposed metal silicide layer can be considered as a hole bottom of the second contact hole. The etching rate of the barrier layer is greater than an etching rate of the metal silicide layer under an etching condition of the barrier layer. In this way, when a conductive layer is deposited in the first contact hole and the second contact hole and the metal silicide layer is conductive, the conductive layer may be electrically connected to the source and the drain through the metal silicide layer, so as to transmit a signal to the source and the drain, thereby helping implement a function of the transistor. The material for manufacturing the barrier layer includes at least one of the following: a non-conductive metal oxide and a non-conductive polymer material. For example, the non-conductive metal oxide may be but is not limited to a tungsten oxide, and the non-conductive polymer material may be but is not limited to polyethylene. As long as the barrier layer can be obtained, a specific manufacturing material is not specifically limited herein.

Further, at least a part of the metal in the material for manufacturing the barrier layer is the same as a metal in the metal silicide layer. That is, when the material for manufacturing the barrier layer includes at least one metal, the metal included in the barrier layer may be the same as the metal in the metal silicide layer. For example, if the metal in the metal silicide layer includes Co, the metal in the barrier layer includes at least Co; if the metal in the metal silicide layer includes Ni, the metal in the barrier layer includes at least Ni; and if the metal in the metal silicide layer includes Ti, the metal in the barrier layer includes at least Ti. Certainly, the metal in the metal silicide layer is not limited to Co, Ni, and Ti, and may alternatively be another metal. Details are not listed herein. In this way, the barrier layer and the metal silicide layer can include a same metal element. This can improve manufacturing quality of the barrier layer, and can further reduce introduced impurities, thereby avoiding some unknown and uncontrollable problems, and improving reliability of the chip.

In addition, a thickness of the barrier layer may be set to 2 nm to 5 nm. For example, the thickness of the barrier layer is set to 2 nm, 3 nm, 4 nm, or 5 nm. When the thickness of the barrier layer is large, manufacturing difficulty of the barrier layer is increased, and a thickness of the chip is increased. As a result, manufacturing costs and a volume of the chip are increased. When the thickness of the barrier layer is small, manufacturing quality of the barrier layer can be reduced. If the barrier layer has a defect like a hole or a gap, the defect in the barrier layer may damage the metal silicide layer when the first contact hole is formed. As a result, the metal silicide layer cannot be effectively protected. Therefore, the thickness of the barrier layer is set within an appropriate range. This can effectively protect the metal silicide layer, reduce manufacturing costs, and avoid an increase in the volume of the chip.

Optionally, the transistor may further include a top gate, and the metal silicide layer is further disposed on the top gate. Therefore, the barrier layer is also disposed on the metal silicide layer corresponding to the top gate, and the top gate overlaps with an orthographic projection that is of at least one first contact hole in the plurality of first contact holes and that is on the substrate, that is, the top gate overlaps with an orthographic projection that is of a part of the first contact holes and that is on the substrate. In this way, when the first contact hole corresponding to the top gate is formed, the barrier layer on the top gate can stop etching. When the etching stop layer is etched, etching on the metal silicide layer can be prevented, and the metal silicide layer can be protected. Even if the metal silicide layer is thin, the top gate in the transistor is not affected, and the top gate is protected. This further improves a manufacturing yield of the chip. It should be understood that, the barrier layer disposed on the metal silicide layer corresponding to the top gate, the barrier layer disposed on the metal silicide layer corresponding to the source, and the barrier layer disposed on the metal silicide layer corresponding to the drain are disposed in the same manner. Therefore, for the manner of disposing the barrier layer disposed on the metal silicide layer corresponding to the top gate, refer to the description in the foregoing related content. No repeated description is provided.

For the etching stop layer and the interlayer dielectric layer, each of the etching stop layer and the interlayer dielectric layer may be made of a non-conductive material. For example, the etching stop layer may be made of SiO₂ or the like, and the interlayer dielectric layer may be made of Si₃N₄ or the like. Alternatively, the etching stop layer may be made of Si₃N₄ or the like, and the interlayer dielectric layer may be made of SiO₂ or the like. Certainly, each of the etching stop layer and the interlayer dielectric layer may alternatively be made of another non-conductive material. Details are not listed herein. In this way, a difference between the etching rate of the barrier layer and the etching rate of the etching stop layer may be large, and a difference between the etching rate of the etching stop layer and an etching rate of the interlayer dielectric layer may be slightly small. Therefore, when the interlayer dielectric layer is etched to form the first contact hole, the etching stop layer may be etched, but it is difficult to etch the barrier layer. Therefore, the barrier layer can stop etching, protect the metal silicide layer, and further protect the source and the drain, thereby improving the manufacturing yield of the chip.

It should be noted that, because the barrier layer can stop etching and protect the metal silicide layer, the metal silicide layer may be set to be thin. For example, a thickness of the metal silicide layer may be set to 2 nm to 5 nm, to form the continuous metal silicide layer, and avoid breaking caused by agglomeration of the metal silicide layer that is thick. This can improve performance and a product yield of the chip, can reduce manufacturing difficulty and manufacturing costs, and can further reduce a volume of the chip.

According to a second aspect, an embodiment of this application further provides a method for manufacturing a chip. The manufacturing method is used to manufacture the chip described in any one of the first aspect or embodiments of the first aspect. The manufacturing method may include: forming a transistor on a substrate, where the transistor includes a source and a drain; forming a metal silicide layer at least on the source and the drain; forming a barrier layer on the metal silicide layer; sequentially forming, on the substrate on which the barrier layer is formed, an etching stop layer and an interlayer dielectric layer, where an etching rate of the etching stop layer is greater than an etching rate of the barrier layer under an etching condition of the etching stop layer; and forming a plurality of first contact holes that penetrate the etching stop layer and the interlayer dielectric layer, where the source overlaps with an orthographic projection that is of at least one first contact hole in the plurality of first contact holes and that is on the substrate, and the drain overlaps with an orthographic projection that is of at least one first contact hole in the plurality of first contact holes and that is on the substrate. In this way, when the first contact hole is formed, because the etching rate of the etching stop layer is greater than the etching rate of the barrier layer under the etching condition of the etching stop layer, etching on the barrier layer can be prevented when the etching stop layer is etched. In addition, a higher etch selectivity ratio of the etching stop layer to the barrier layer indicates a lower probability of etching the barrier layer, so that the barrier layer can stop etching, etching on the metal silicide layer can be prevented, and the metal silicide layer can be protected. Even if the metal silicide layer is thin, the source and the drain in the transistor are not affected, and the source and the drain are protected. This improves a manufacturing yield of the chip.

Optionally, forming the metal silicide layer may specifically include: when the transistor further includes a top gate, separately forming the metal silicide layer on the source, the drain, and the top gate. In this way, the metal silicide layer and the barrier layer are also sequentially disposed on the top gate, and the barrier layer on the top gate can stop etching. When the etching stop layer is etched, etching on the metal silicide layer can be prevented, and the metal silicide layer can be protected. Even if the metal silicide layer is thin, the top gate in the transistor is not affected, and the top gate is protected. This further improves a manufacturing yield of the chip.

Optionally, the manufacturing method may further include: before forming the first contact hole and after forming the interlayer dielectric layer, performing heat treatment on the substrate on which the interlayer dielectric layer is formed, so as to form a continuous metal silicide layer, thereby reducing contact resistance between a conductive layer in the first contact hole and the source, the drain, the top gate, and improving performance and a product yield of the chip. When the metal silicide layer includes Co, heat treatment may be performed twice when the metal silicide layer is formed. In this case, forming the metal silicide layer on the source and the drain may specifically include: An amorphous silicon layer and a Co layer are sequentially formed on the source and the drain, and then, rapid annealing is performed, for the amorphous silicon layer to react with the Co layer, to form a high-resistance-phase cobalt silicide layer. Rapid annealing is first heat treatment. In this case, before the first contact hole is formed and after the interlayer dielectric layer is formed, heat treatment is performed on the substrate on which the interlayer dielectric layer is formed. Heat treatment may be considered as second heat treatment, that is, high-temperature rapid annealing, so that the high-resistance-phase cobalt silicide layer is converted into a low-resistance-phase cobalt silicide layer, and the low-resistance-phase cobalt silicide layer is used as the metal silicide layer. Certainly, when the metal silicide layer includes another metal, the metal silicide layer may be obtained by performing heat treatment only once. For example, before the first contact hole is formed and after the interlayer dielectric layer is formed, heat treatment may be performed on the substrate on which the interlayer dielectric layer is formed. Therefore, a process of forming the metal silicide layer may be designed based on an actual situation. This is not limited herein.

Optionally, forming the barrier layer may specifically include: forming the barrier layer by using a non-conductive material. In this case, the manufacturing method may further include: after forming the barrier layer and before forming the etching stop layer, forming a plurality of second contact holes that penetrate the barrier layer, where the second contact holes are disposed in correspondence to the first contact holes and communicate with the first contact holes, and the etching rate of the barrier layer is greater than an etching rate of the metal silicide layer under an etching condition of the barrier layer. In this way, when the first contact hole communicates with the second contact hole, the conductive layer is deposited in both the first contact hole and the second contact hole, and the metal silicide layer is conductive, the conductive layer may be electrically connected to the source and the drain through the metal silicide layer, so as to transmit a signal to the source and the drain, thereby helping implement a function of the transistor. In addition, because the etching rate of the barrier layer is greater than the etching rate of the metal silicide layer under the etching condition of the barrier layer, etching on the metal silicide layer can be prevented when the barrier layer is etched. In addition, a higher etch selectivity ratio of the barrier layer to the metal silicide layer indicates a lower probability of etching the metal silicide layer. This can avoid damage to the source and the drain, and further improves a manufacturing yield of the chip.

Certainly, when the barrier layer is formed, if the barrier layer is formed by using a conductive material, the second contact hole does not need to be disposed in the barrier layer, so that the barrier layer is exposed in the first contact hole. In addition, the exposed barrier layer may be considered as a hole bottom of the first contact hole. In this case, the conductive layer in the first contact hole may be electrically connected to the source and the drain through the barrier layer and the metal silicide layer, so as to transmit a signal to the source and the drain. In addition, a process of disposing the second contact hole may be omitted. This can simplify a manufacturing process, and reduce manufacturing costs.

It should be understood that, because a problem-resolving principle of the manufacturing method during chip manufacturing is similar to a problem-resolving principle of the chip, for implementation and technical effect of the manufacturing method, refer to implementation and technical effect of the chip. No repeated description is provided.

According to a third aspect, an embodiment of this application further provides an electronic device. The electronic device may include a circuit board and the chip described in any one of the first aspect and embodiments of the first aspect. The chip is disposed on the circuit board. In this way, on the basis of improving a manufacturing yield of the chip, a manufacturing yield of the electronic device can be improved, and performance of the electronic device can further be improved. It should be understood that, because a problem-resolving principle of the electronic device is similar to a problem-resolving principle of the chip, for implementation and technical effect of the electronic device, refer to implementation and technical effect of the chip. No repeated description is provided.

### BRIEF DESCRIPTION OF DRAWINGS

FIG. 1 is a diagram of a structure of an electronic device according to an embodiment of this application;
FIG. 2 is a diagram of a structure of a chip according to an embodiment of this application;
FIG. 3 is a diagram of a structure of another chip according to an embodiment of this application;
FIG. 4A and FIG. 4B are diagrams of a structure of still another chip according to an embodiment of this application;
FIG. 5A to FIG. 5E are a flowchart of a method for manufacturing a chip according to an embodiment of this application; and
FIG. 6A to FIG. 6E are a flowchart of another method for manufacturing a chip according to an embodiment of this application.

Reference numerals:
10: substrate, 11: source, 12: drain, 13a: bottom gate, 13b: top gate, 14: channel, 15: gate insulation layer, 16: side wall, 20: metal silicide layer, 30: barrier layer, 30a: non-conductive barrier layer, 40: etching stop layer, 50: interlayer dielectric layer, 61: first contact hole, 62: second contact hole, 70: conductive layer, m1: transistor, 100: housing, 200: circuit board, and 300: chip.

### DESCRIPTION OF EMBODIMENTS

To make objectives, technical solutions, and advantages of this application clearer, the following further describes this application in detail with reference to accompanying drawings.

It should be noted that same reference numerals in the accompanying drawings of this application indicate same or similar structures. Therefore, repeated descriptions thereof are omitted. Expressions of positions and directions in this application are described by using the accompanying drawings as examples. However, changes may also be made as required, and all the changes fall within the protection scope of this application. The accompanying drawings in this application are merely used to illustrate relative position relationships and do not represent an actual scale.

For ease of understanding of the technical solutions provided in embodiments of this application, the following first describes application scenarios of the technical solutions.

A chip provided in embodiments of this application may be widely used in various electronic devices. The electronic device may include various terminal devices and electronic components. The terminal device may include but is not limited to devices such as a smartphone, a smart television, a smart television set-top box, a smartwatch, a personal computer (personal computer, PC), a wearable device, and an intelligent broadband device. The electronic component may include but is not limited to a telecommunication device like a wireless network, a fixed network, and a server, and a component like a chip module or a memory. Details are not described herein.

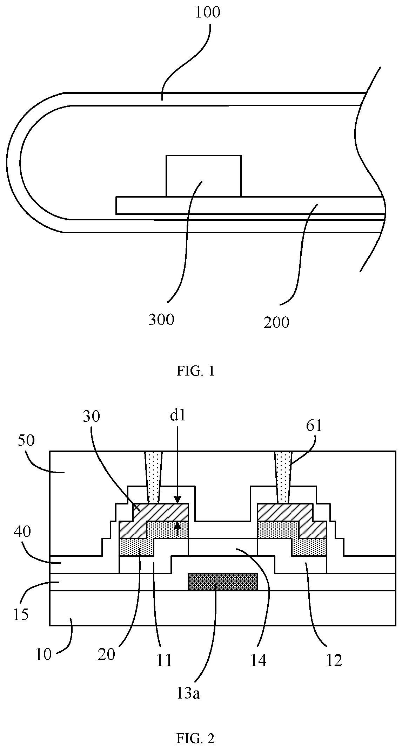

FIG. 1 is a diagram of an example of a structure of an electronic device in which a chip is used. As shown in FIG. 1, the electronic device includes a housing 100 and a circuit board 200 disposed in the housing 100. The chip 300 is disposed on the circuit board 200. The chip 300 includes a substrate, and a transistor, an etching stop layer, and an interlayer dielectric layer that are sequentially disposed on the substrate. A through contact hole is disposed in the etching stop layer and the interlayer dielectric layer. When a metal is deposited in the contact hole, the metal may be electrically connected to a top gate, a source, and a drain in the transistor, so as to transmit a signal to the top gate, the source, and the drain, thereby implementing a function of the transistor. The source is used as an example. To improve effect of an electrical connection between the metal in the contact hole and the source and reduce contact resistance, a metal silicide layer may be disposed between the source and the etching stop layer. Conductivity of the metal silicide layer is between that of the metal and that of silicon, and the metal silicide layer may be used as a transition layer for contact between the metal and a semiconductor, to help form ohmic contact between the metal and a semiconductor layer, thereby reducing contact resistance.

The metal silicide layer may be made of nickel silicide. The nickel silicide has a low formation temperature, low silicon consumption, and no line width effect. However, the nickel silicide has low thermal stability, and degradation occurs at a temperature higher than 500°C. This characteristic limits use of the nickel silicide in a high-temperature process scenario. Compared with the nickel silicide, cobalt silicide (namely, CoSi₂) has good high-temperature thermal stability, good conductivity, and a low silicon mismatch rate. When the cobalt silicide is formed, a metal cobalt is first deposited on amorphous silicon, then low-temperature rapid annealing is performed to form high-resistance-phase CoSi, and then, high-temperature rapid annealing is performed to form low-resistance-phase CoSi₂. However, the cobalt silicide is prone to agglomeration in a process of forming the low-resistance-phase CoSi₂. Consequently, CoSi₂ is broken, and device performance and a product yield are severely affected. To resolve a problem of breaking of the cobalt silicide, a thickness of the deposited metal cobalt is usually controlled, to reduce grains of the cobalt silicide, prevent formation of excessively thick high-resistance-phase CoSi, and help form a continuous cobalt silicide layer after high-temperature rapid annealing. However, when the contact hole is manufactured in the etching stop layer and the interlayer dielectric layer, over-etching may occur. When the metal silicide layer is thin, the metal silicide layer may be etched away, and the top gate, the source, and the drain may be affected. As a result, a manufacturing yield of the chip is reduced.

In view of this, embodiments of this application provide a chip, a method for manufacturing the chip, and an electronic device. Even if a thickness of a metal silicide layer is small, an electrode in a transistor can still be unaffected. This improves a manufacturing yield of the chip. The following describes in detail a specific structure of a chip and a specific method for manufacturing the chip provided in embodiments of this application with reference to specific embodiments.

FIG. 2 is a diagram of an example of a structure of a chip according to an embodiment of this application. As shown in FIG. 2, the chip includes a substrate 10, and a transistor, a metal silicide layer 20, a barrier layer 30, an etching stop layer 40, and an interlayer dielectric layer 50 that are sequentially stacked on the substrate 10. The transistor may be a bottom-gate transistor. Therefore, the transistor may include a source 11, a drain 12, a bottom gate 13a, and a channel 14. The bottom gate 13a is disposed between the channel 14 and the substrate 10. The source 11 and the drain 12 are respectively disposed on two opposite sides of the channel 14. The source 11 and the drain 12 are separately connected to the channel 14. A gate insulation layer 15 is disposed between the bottom gate 13a and the channel 14. The gate insulation layer 15 may isolate the channel 14 from the bottom gate 13a. The metal silicide layer 20 is disposed on the source 11 and the drain 12, in other words, the source 11 and the drain 12 are provided with the metal silicide layer 20, and the metal silicide layer 20 is not disposed at another position. The barrier layer 30 is disposed on the metal silicide layer 20, and the barrier layer 30 is not disposed in a region in which the metal silicide layer 20 is not disposed. In this case, the metal silicide layer 20 and the barrier layer 30 are disposed between the source 11 and the etching stop layer 40, and the metal silicide layer 20 and the barrier layer 30 are also disposed between the drain 12 and the etching stop layer 40. The chip further includes a first contact hole 61. The first contact hole 61 penetrates the etching stop layer 40 and the interlayer dielectric layer 50, and a plurality of first contact holes 61 may be disposed. A part of the first contact holes 61 overlap with an orthographic projection that is of the source 11 and that is on the substrate 10, and another part of the first contact holes 61 overlap with an orthographic projection that is of the drain 12 and that is on the substrate 10. The barrier layer 30 may be made of a conductive material, so that the barrier layer 30 may be a conductive barrier layer. In addition, the barrier layer 30 may be exposed in a first contact hole 61 corresponding to the source 11, so that an exposed part of the barrier layer 30 can be considered as a hole bottom of the first contact hole 61 corresponding to the source 11. The barrier layer 30 may be exposed in a first contact hole 61 corresponding to the drain 12, so that an exposed part of the barrier layer 30 can be considered as a hole bottom of the first contact hole 61 corresponding to the drain 12. In this way, if an etching rate of the etching stop layer 40 is greater than an etching rate of the barrier layer 30 under an etching condition of the etching stop layer 40, when the etching stop layer 40 is etched, etching on the barrier layer 30 can be prevented. In addition, a higher etch selectivity ratio of the etching stop layer 40 to the barrier layer 30 indicates a lower probability of etching the barrier layer 30, so that the barrier layer 30 can stop etching, etching on the metal silicide layer 20 can be prevented, and the metal silicide layer 20 can be protected. Even if the metal silicide layer 20 is thin, the source 11 and the drain 12 in the transistor are not affected, and the source 11 and the drain 12 are protected. This improves a manufacturing yield of the chip. In addition, when a conductive layer is deposited in the first contact hole 61 and the metal silicide layer 20 is conductive, the conductive layer may be electrically connected to the source 11 and the drain 12 through the barrier layer 30 and the metal silicide layer 20, so as to transmit a signal to the source 11 and the drain 12, thereby helping implement a function of the transistor.

A material for manufacturing the barrier layer 30 includes at least one of the following: a metal, a conductive metal oxide, and a conductive polymer material. For example, the metal may be but is not limited to a conductive pure metal, or a conductive metal alloy, or a combination of a conductive pure metal and a conductive metal alloy; the conductive metal oxide may be but is not limited to an indium tin oxide; and the conductive polymer material may be but is not limited to doped polyacetylene. As long as the barrier layer 30 can be obtained, a specific manufacturing material is not specifically limited herein.

Further, when the material for manufacturing the barrier layer 30 includes at least one metal, the metal included in the barrier layer 30 may be the same as a metal in the metal silicide layer 20. For example, if the metal in the metal silicide layer 20 includes Co, the metal in the barrier layer 30 includes at least Co; if the metal in the metal silicide layer 20 includes Ni, the metal in the barrier layer 30 includes at least Ni; and if the metal in the metal silicide layer 20 includes Ti, the metal in the barrier layer 30 includes at least Ti. Certainly, the metal in the metal silicide layer 20 is not limited to Co, Ni, and Ti, and may alternatively be another metal. Details are not listed herein. In this way, the barrier layer 30 and the metal silicide layer 20 can include a same metal element. This can improve manufacturing quality of the barrier layer 30, and can further reduce introduced impurities, thereby avoiding some unknown and uncontrollable problems, and improving reliability of the chip.

In addition, a thickness d1 of the barrier layer 30 may be set to 2 nm to 5 nm. For example, the thickness d1 of the barrier layer 30 is set to 2 nm, 3 nm, 4 nm, or 5 nm. When the thickness d1 of the barrier layer 30 is large, manufacturing difficulty of the barrier layer 30 is increased, and a thickness d1 of the chip is increased. As a result, manufacturing costs and a volume of the chip are increased. When the thickness d1 of the barrier layer 30 is small, manufacturing quality of the barrier layer 30 can be reduced. If the barrier layer 30 has a defect like a hole or a gap, the defect in the barrier layer 30 may damage the metal silicide layer 20 when the first contact hole 61 is formed. As a result, the metal silicide layer 20 cannot be effectively protected. Therefore, the thickness d1 of the barrier layer 30 is set within an appropriate range. This can effectively protect the metal silicide layer 20, reduce manufacturing costs, and avoid an increase in the volume of the chip.

In addition, each of the etching stop layer 40 and the interlayer dielectric layer 50 may be made of a non-conductive material. For example, the etching stop layer 40 may be made of SiO₂ or the like, and the interlayer dielectric layer 50 may be made of Si₃N₄ or the like. Alternatively, the etching stop layer 40 may be made of Si₃N₄ or the like, and the interlayer dielectric layer 50 may be made of SiO₂ or the like. Certainly, each of the etching stop layer 40 and the interlayer dielectric layer 50 may alternatively be made of another non-conductive material. Details are not listed herein. In this way, a difference between the etching rate of the barrier layer 30 and the etching rate of the etching stop layer 40 may be large, and a difference between the etching rate of the etching stop layer 40 and an etching rate of the interlayer dielectric layer 50 may be slightly small. Therefore, when the interlayer dielectric layer 50 is etched to form the first contact hole 61, the etching stop layer 40 may be etched, but it is difficult to etch the barrier layer 30. Therefore, the barrier layer 30 can stop etching, protect the metal silicide layer 20, and further protect the source 11 and the drain 12, thereby improving the manufacturing yield of the chip.

It should be noted that, because the barrier layer 30 can stop etching and protect the metal silicide layer 20, the metal silicide layer 20 may be set to be thin. For example, a thickness of the metal silicide layer 20 may be set to 2 nm to 5 nm, to form the continuous metal silicide layer 20, and avoid breaking caused by agglomeration of the metal silicide layer 20 that is thick. This can improve performance and a product yield of the chip, can reduce manufacturing difficulty and manufacturing costs, and can further reduce a volume of the chip.

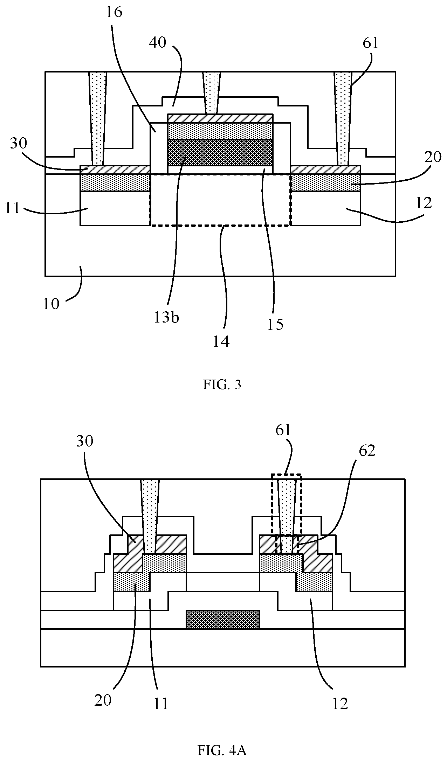

FIG. 3 is a diagram of an example of a structure of a chip according to an embodiment of this application. As shown in FIG. 3, the structure of the chip in this embodiment is basically similar to the structure of the chip described in the embodiment shown in FIG. 2. A difference lies in that a transistor is a top-gate transistor or a dual-gate transistor, that is, the transistor includes a top-gate structure. Optionally, the top-gate structure includes a top gate 13b, a side wall 16, and a gate insulation layer 15 disposed between the top gate 13b and the channel 14. The gate insulation layer 15 may isolate the channel 14 from the top gate 13b. The side wall 16 is disposed on a side surface of the top gate 13b. The side wall 16 may isolate the top gate 13b from a source 11 and isolate the top gate 13b from a drain 12, to avoid short-circuiting between the top gate 13b and the source 11 and avoid short-circuiting between the top gate 13b and the drain 12. A substrate 10 may be a silicon substrate. In this case, the channel 14, the source 11, and the drain 12 may be formed in the substrate 10, the source 11 and the drain 12 are respectively disposed on two opposite sides of the channel 14, and both the source 11 and the drain 12 are connected to the channel 14. A metal silicide layer 20 and a barrier layer 30 are sequentially disposed on a source 11 and a drain 12, and the metal silicide layer 20 and the barrier layer 30 are further sequentially disposed on the top gate 13b. In addition, a part of first contact holes 61 overlap with an orthographic projection that is of the top gate 13b and that is on the substrate 10. The barrier layer 30 is exposed in a first contact hole 61 corresponding to the top gate 13b, so that an exposed part of the barrier layer 30 can be considered as a hole bottom of the first contact hole 61 corresponding to the top gate 13b. In this way, when the first contact hole 61 corresponding to the top gate 13b is formed, the barrier layer 30 on the top gate 13b can stop etching. When the etching stop layer 40 is etched, etching on the metal silicide layer 20 can be prevented, and the metal silicide layer 20 can be protected. Even if the metal silicide layer 20 is thin, the top gate 13b in the transistor is not affected, and the top gate 13b is protected. This further improves a manufacturing yield of the chip.

A specific implementation of the metal silicide layer 20 and the barrier layer 30 that are located on the top gate 13b is the same as the specific implementation of the metal silicide layer 20 and the barrier layer 30 described in the embodiment shown in FIG. 2. Therefore, for the specific implementation of the metal silicide layer 20 and the barrier layer 30 that are located on the top gate 13b, refer to related descriptions in the embodiment shown in FIG. 2. No repeated description is provided. In addition, for similarities between the structure of the chip in this embodiment and the structure of the chip described in the embodiment shown in FIG. 2, refer to related descriptions in the embodiment shown in FIG. 2. No repeated description is provided.

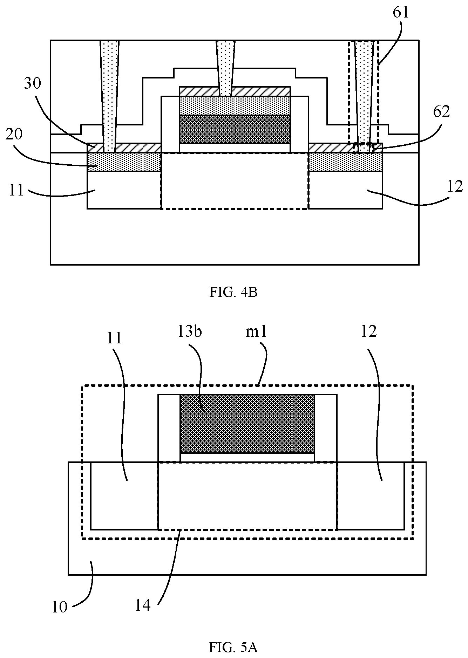

FIG. 4A and FIG. 4B are diagrams of an example of a structure of a chip according to an embodiment of this application. As shown in FIG. 4A and FIG. 4B, the structure of the chip in this embodiment is basically similar to the structure of the chip described in the embodiment shown in FIG. 2 or the embodiment shown in FIG. 3. That is, a structure of the chip shown in in FIG. 4A is basically similar to the structure of the chip shown in FIG. 2, and a structure of the chip shown in FIG. 4B is basically similar to the structure of the chip shown in FIG. 3. A difference lies in that a barrier layer 30 is made of a non-conductive material. Therefore, the barrier layer 30 may be a non-conductive barrier layer. Optionally, a second contact hole 62 corresponding to each first contact hole 61 is disposed in the barrier layer 30, the second contact hole 62 penetrates the barrier layer 30, and the second contact hole 62 communicates with the corresponding first contact hole 61. A metal silicide layer 20 may be exposed in the second contact hole 62, so that the exposed metal silicide layer 20 can be considered as a hole bottom of the second contact hole 62. An etching rate of the barrier layer 30 is greater than an etching rate of the metal silicide layer 20 under an etching condition of the barrier layer 30. In this way, when a conductive layer is deposited in the first contact hole 61 and the second contact hole 62 and the metal silicide layer 20 is conductive, the conductive layer may be electrically connected to a source 11 and a drain 12 through the metal silicide layer 20, so as to transmit a signal to the source 11 and the drain 12, thereby helping implement a function of a transistor. A material for manufacturing the barrier layer 30 includes at least one of the following: a non-conductive metal oxide and a non-conductive polymer material. For example, the non-conductive metal oxide may be but is not limited to a tungsten oxide, and the non-conductive polymer material may be but is not limited to polyethylene. As long as the barrier layer 30 can be obtained, a specific manufacturing material is not specifically limited herein.

It should be understood that, for similarities between the structure of the chip in this embodiment and the structure of the chip described in the embodiment shown in FIG. 2 or the embodiment shown in FIG. 3, refer to related descriptions in the embodiment shown in FIG. 2 or the embodiment shown in FIG. 3. No repeated description is provided.

FIG. 5A to FIG. 5E are a flowchart of an example of a method for manufacturing a chip according to an embodiment of this application. As shown in FIG. 5A to FIG. 5E, the manufacturing method may include the following steps.

Step 1: As shown in FIG. 5A, form a transistor m1 on a substrate 10.

The transistor m1 may be a bottom-gate transistor, or may be a top-gate transistor or a dual-gate transistor. FIG. 5A to FIG. 5E show an example in which the top-gate transistor is used. However, this does not mean that the transistor m1 can only be a top-gate transistor. In addition, the substrate 10 may be made of a polycrystalline silicon material. In this case, a source 11, a drain 12, and a channel 14 in the top-gate transistor may be all formed in the substrate 10, the polycrystalline silicon is used as the channel 14, and the source 11 and the drain 12 may be obtained through polycrystalline silicon doping on both sides of the channel 14. A top gate 13b in the top-gate transistor may be disposed on the substrate 10, to form a structure shown in FIG. 5A. In addition, there may be at least one transistor m1 disposed on the substrate 10. A metal silicide layer and a conductive barrier layer are formed on the source 11, the drain 12, and the top gate 13b in each transistor m1.

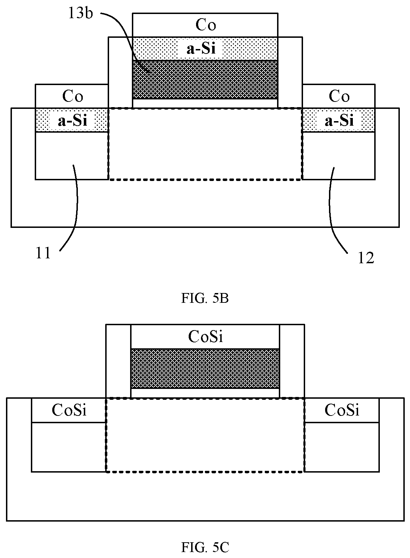

Step 2: As shown in FIG. 5B, sequentially form an amorphous silicon layer (that is, an a-Si layer) and a Co layer on the source 11, the drain 12, and the top gate 13b in the transistor.

Before the amorphous silicon layer is formed, a mask layer with a predetermined pattern may be formed on the substrate with the transistor by using a patterning method, the source, the drain, and the top gate may be exposed through the mask layer, and another position may be blocked. In this case, the amorphous silicon layer and the Co layer are sequentially deposited, and then, the mask layer is etched away, so that the amorphous silicon layer and the Co layer exist on the source, the drain, and the top gate, and the amorphous silicon layer and the Co layer do not exist at the another position. The mask layer may be made of a photoresist or another material, and may be specifically selected based on an actual requirement. This is not limited herein.

If the source, the drain, and the top gate are all made of a doped polycrystalline silicon material, ion implantation may be performed on the source, the drain, and the top gate in a pre-amorphization ion implantation manner, so that polycrystalline silicon in a part of the source, a part of the drain, and a part of the top gate is converted into amorphous silicon, polycrystalline silicon that is not converted in the source continues to be used as the source, polycrystalline silicon that is not converted in the drain continues to be used as the drain, and polycrystalline silicon that is not converted in the top gate continues to be used as the top gate, to form the amorphous silicon layer located on the source, the drain, and the top gate. Optionally, an implantation condition may include: An ion implantation source may be a Ge ion or an Xe ion, ion implantation energy may be 2 keV to 10 keV, and an ion implantation dose is 10¹⁴ atoms/cm² to 10¹⁵ atoms/cm². Certainly, the implantation condition is not limited thereto. Alternatively, another ion implantation source, other ion implantation energy, and another ion implantation dose may be selected. This may be specifically designed based on an actual requirement, and is not limited herein.

When the Co layer is formed, the Co layer may be manufactured by using a physical vapor deposition method, and a thickness of the manufactured Co layer may be controlled to 20 nm to 40 nm. Certainly, a metal layer located on the amorphous silicon layer is not limited to the Co layer, and may also be an Ni layer or a Ti layer. Herein, only Co is used as an example for description.

Step 3: As shown in FIG. 5C, perform rapid thermal annealing, for Co to react with Si, so as to form a high-resistance-phase CoSi layer, where the high-resistance-phase CoSi layer may be considered as an initial layer, and remove the unreacted Co layer located on the initial layer.

During rapid thermal annealing, a specific annealing condition may include: An annealing temperature is 380°C to 540°C, and an annealing time is 30 minutes to 120 minutes. Certainly, the annealing condition is not limited thereto, or may be another condition designed based on an actual requirement. This is not limited herein.

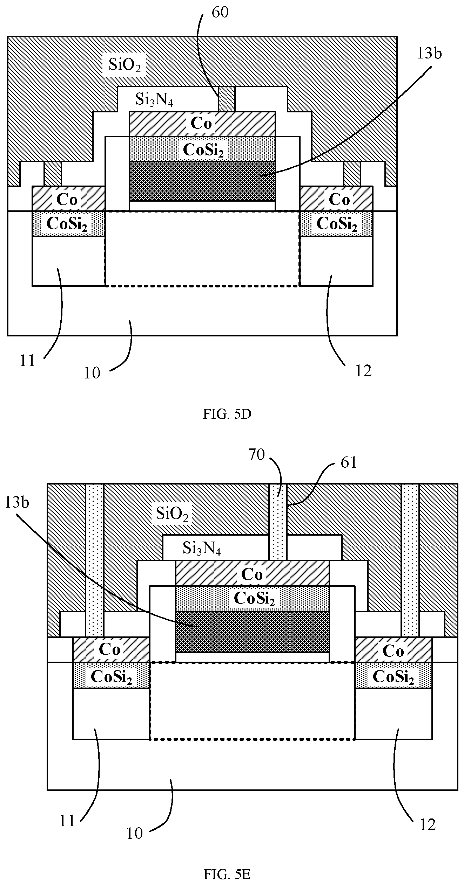

Step 4: As shown in FIG. 5D, form a Co layer on the initial layer by using, but not limited to, Co. The Co layer is used as a conductive barrier layer, and a thickness of the Co layer may be controlled to 2 nm to 5 nm.

It should be noted that, when the Co layer is formed as the conductive barrier layer, the Co layer is formed only on the initial layer, and the Co layer is not formed at another position. In this case, a manufacturing method for forming the Co layer may include: A mask layer with a predetermined pattern is formed on the substrate with the initial layer by using the patterning method, the initial layer may be exposed via the mask layer, and the another position is blocked. In this case, the entire Co layer is deposited by using the physical vapor deposition method. Then, the mask layer is etched away, so that the Co layer exists on the initial layer, and the Co layer does not exist at the another position. Certainly, when the Co layer is formed, another method that can implement regional selective deposition may alternatively be used, so that the Co layer is deposited only on the initial layer, and the Co layer is not deposited at the another position. This is not limited herein.

Step 5: Still as shown in FIG. 5D, deposit, by using a chemical vapor deposition method, an entire Si₃N₄ layer on the substrate 10 on which the Co layer is formed, where the Si₃N₄ layer may be used as an etching stop layer, and a thickness of the Si₃N₄ layer is controlled to 20 nm to 30 nm.

Step 6: Still as shown in FIG. 5D, etch the Si₃N₄ layer to obtain a plurality of initial holes 60 that penetrate the Si₃N₄ layer, where the Co layer is exposed from the initial holes 60, and the initial holes 60 respectively overlap with orthographic projections that are of the source 11, the drain 12, and the top gate 13b and that are on the substrate 10.

Before etching is performed, a mask layer with a predetermined pattern may be formed on the Si₃N₄ layer by using the patterning method. A position at which the initial hole needs to be formed may be exposed via the mask layer, and another position is blocked. Therefore, during etching, only an exposed position may be etched, and an unexposed position may not be etched, to manufacture each initial hole in the Si₃N₄ layer. Then, the mask layer is removed, to continue to manufacture another structure.

Step 7: Still as shown in FIG. 5D, perform high-temperature rapid annealing, to convert the high-resistance-phase CoSi layer as the initial layer into a low-resistance-phase CoSi₂ layer, where the low-resistance-phase CoSi₂ layer is used as the metal silicide layer.

During high-temperature rapid annealing, a specific annealing condition may include: An annealing temperature is 600°C to 900°C, and an annealing time is 5s to 30s. Certainly, the annealing condition is not limited thereto, or may be another condition designed based on an actual requirement. This is not limited herein.

In addition, a sequence of performing step 6 and step 7 may be exchanged, that is, step 7 is performed before step 6. This is not limited herein.

Step 8: Still as shown in FIG. 5D, deposit an entire SiO₂ layer on the Si₃N₄ layer by using the chemical vapor deposition method, where the SiO₂ layer is used as an interlayer dielectric layer, and the initial hole 60 is also filled with SiO₂.

Step 9: As shown in FIG. 5E, perform etching on the SiO₂ layer and SiO₂ in the initial holes 60, to obtain a plurality of first contact holes 61 that penetrate the SiO₂ layer and the initial holes 60, where the first contact holes 61 are disposed in one-to-one correspondence to the initial holes, the Co layer is exposed from the first contact holes 61, and the first contact holes 61 respectively overlap with the orthographic projections that are of the source 11, the drain 12, and the top gate 13b and that are on the substrate 10.

Similarly, a manner of manufacturing the first contact hole is the same as a manner of manufacturing the initial hole. Details are not described herein again.

Step 10: Still as shown in FIG. 5E, deposit a conductive layer 70 in the first contact hole 61 by using the physical vapor deposition method, so that the conductive layer 70 in the first contact hole 61 is in contact with the Co layer.

In this way, because the conductive barrier layer has a conductive function, when the metal silicide layer also has a conductive function, the conductive layer in a first contact hole corresponding to the top gate may be electrically connected to the top gate through the conductive barrier layer and the metal silicide layer, the conductive layer in a first contact hole corresponding to the source may be electrically connected to the source through the conductive barrier layer and the metal silicide layer, and the conductive layer in a first contact hole corresponding to the drain may be electrically connected to the drain through the conductive barrier layer and the metal silicide layer, to provide corresponding electrical signals for the top gate, the source, and the drain respectively, to implement a function of the transistor.

In addition, when the first contact hole is formed, the SiO₂ layer and the Si₃N₄ layer are mainly consumed, and the SiO₂ layer and the Si₃N₄ layer have a higher etch selectivity ratio than the Co layer. Therefore, the conductive barrier layer can stop etching. When the etching stop layer is etched, etching on the metal silicide layer can be prevented, and the metal silicide layer can be protected. Even if the metal silicide layer is thin, the source, the drain, and the top gate in the transistor are not affected, and the source, the drain, and the top gate are protected. This improves a manufacturing yield of the chip.

In addition, when the conductive barrier layer is formed, the conductive barrier layer is formed only on the initial layer by using the regional selective deposition method, and the conductive barrier layer is not formed at another position. Therefore, the conductive barrier layer only protects the metal silicide layer located below the conductive barrier layer, and does not affect another structure, thereby further improving the manufacturing yield of the chip.

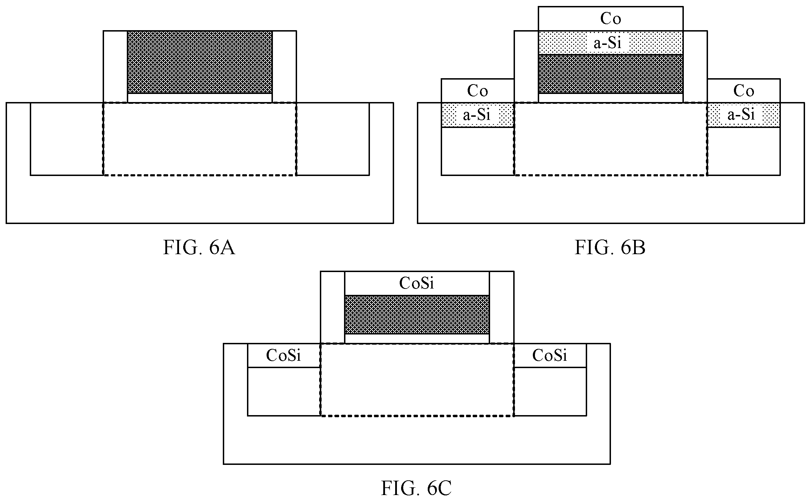

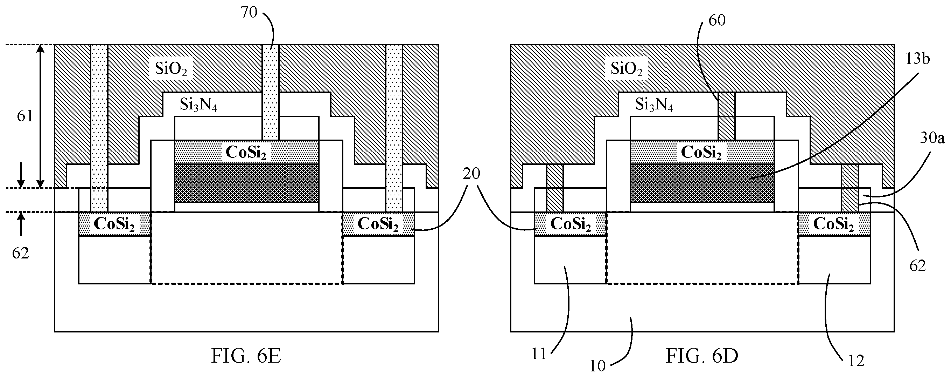

FIG. 6A to FIG. 6E are a flowchart of an example of a method for manufacturing a chip according to an embodiment of this application. As shown in FIG. 6A to FIG. 6E, the manufacturing method in this embodiment is basically similar to the manufacturing method described in the embodiment shown in FIG. 5A to FIG. 5E, and a difference includes:
(1) Step 4 in the manufacturing method in the previous embodiment is modified as follows: As shown in FIG. 6D, a non-conductive barrier layer 30a is formed by a non-conductive material on an initial layer, and a thickness of the non-conductive barrier layer 30a may be controlled to 2 nm to 5 nm. A method for manufacturing the non-conductive barrier layer 30a is the same as the method for manufacturing the Co layer in the previous embodiment. For details, refer to related descriptions in the previous embodiment. Details are not described herein again.
(2) Step s1 is added between step 4 and step 5 in the manufacturing method in the previous embodiment. Step s1 is as follows: Still as shown in FIG. 6D, the non-conductive barrier layer 30a is etched, to obtain a plurality of second contact holes 62 that penetrate the non-conductive barrier layer 30a. A metal silicide layer 20 is exposed from the second contact holes 62, and the second contact holes 62 respectively overlap with orthographic projections that are of the source 11, the drain 12, and the top gate 13b and that are on the substrate 10. Because an etching rate of the non-conductive barrier layer 30a is greater than an etching rate of the metal silicide layer 20 under an etching condition of the non-conductive barrier layer 30a, when the non-conductive barrier layer 30a is etched, the metal silicide layer 20 can stop etching, and the metal silicide layer 20 can protect the source 11, the drain 12, and the top gate 13b below the metal silicide layer 20.
(3) In step 6 in the manufacturing method in the previous embodiment, obtained initial holes 60 may be disposed in one-to-one correspondence to the second contact holes 62 and communicate with the second contact holes 62.
(4) In step 8 in the manufacturing method in the previous embodiment, the initial hole 60 is filled with SiO₂, and the second contact hole 60 is filled with SiO₂.
(5) Step 9 in the manufacturing method in the previous embodiment is modified as follows: As shown in FIG. 6E, a conductive layer 70 is deposited in a first contact hole 61 and the second contact hole 62 by using a physical vapor deposition method, so that the conductive layer 70 in the corresponding first contact hole 61 and second contact hole 62 is in contact with the metal silicide layer 20.

It should be understood that, for similarities between the manufacturing method in this embodiment and the manufacturing method described in the embodiment shown in FIG. 5A to FIG. 5E, refer to related descriptions in the embodiment shown in FIG. 5A to FIG. 5E. No repeated description is provided.

Clearly, persons skilled in the art can make various modifications and variations to embodiments of this application without departing from the spirit and scope of embodiments of this application. In this case, this application is intended to cover these modifications and variations of embodiments of this application provided that they fall within the scope of protection defined by the following claims and their equivalent technologies.

## Claims

1. A chip, comprising: a transistor, a metal silicide layer, an etching stop layer, an interlayer dielectric layer, and a plurality of first contact holes that are sequentially stacked, wherein the transistor comprises a source and a drain, the metal silicide layer is disposed at least on the source and the drain, the first contact hole penetrates the etching stop layer and the interlayer dielectric layer, the source overlaps with an orthographic projection that is of at least one first contact hole in the plurality of first contact holes and that is on the substrate, and the drain overlaps with an orthographic projection that is of at least one first contact hole in the plurality of first contact holes and that is on the substrate; and
the chip further comprises a barrier layer, the barrier layer is disposed between the metal silicide layer and the etching stop layer, and an etching rate of the etching stop layer is greater than an etching rate of the barrier layer under an etching condition of the etching stop layer.

2. The chip according to claim 1, wherein the barrier layer is made of a conductive material, and the barrier layer is exposed in the first contact hole.

3. The chip according to claim 2, wherein a material for manufacturing the barrier layer comprises at least one of the following: a metal, a conductive metal oxide, and a conductive polymer material.

4. The chip according to any one of claims 1 to 3, wherein the barrier layer is made of a non-conductive material, a second contact hole corresponding to each first contact hole is disposed in the barrier layer, the second contact hole penetrates the barrier layer, and the second contact hole communicates with the corresponding first contact hole; and
the etching rate of the barrier layer is greater than an etching rate of the metal silicide layer under an etching condition of the barrier layer.

5. The chip according to claim 4, wherein the material for manufacturing the barrier layer comprises at least one of the following: a non-conductive metal oxide and a non-conductive polymer material.

6. The chip according to claim 3 or 5, wherein at least a part of the metal in the material for manufacturing the barrier layer is the same as a metal in the metal silicide layer.

7. The chip according to any one of claims 1 to 6, wherein the metal in the metal silicide layer comprises Co.

8. The chip according to any one of claims 1 to 7, wherein a thickness of the barrier layer is 2 nm to 5 nm.

9. The chip according to any one of claims 1 to 8, wherein the transistor further comprises a top gate, the metal silicide layer is further disposed on the top gate, and the top gate overlaps with an orthographic projection that is of at least one first contact hole in the plurality of first contact holes and that is on the substrate.

10. The chip according to any one of claims 1 to 9, wherein each of the etching stop layer and the interlayer dielectric layer is made of a non-conductive material.

11. A method for manufacturing the chip according to any one of claims 1 to 10, comprising:
forming a transistor on a substrate, wherein the transistor comprises a source and a drain;
forming a metal silicide layer at least on the source and the drain;
forming a barrier layer on the metal silicide layer;
sequentially forming, on the substrate on which the barrier layer is formed, an etching stop layer and an interlayer dielectric layer, wherein an etching rate of the etching stop layer is greater than an etching rate of the barrier layer under an etching condition of the etching stop layer; and
forming a plurality of first contact holes that penetrate the etching stop layer and the interlayer dielectric layer, wherein the source overlaps with an orthographic projection that is of at least one first contact hole in the plurality of first contact holes and that is on the substrate, and the drain overlaps with an orthographic projection that is of at least one first contact hole in the plurality of first contact holes and that is on the substrate.

12. The method according to claim 11, wherein forming the metal silicide layer specifically comprises:
when the transistor further comprises a top gate, separately forming the metal silicide layer on the source, the drain, and the top gate.

13. The method according to claim 11 or 12, further comprising:
before forming the first contact hole and after forming the interlayer dielectric layer, performing heat treatment on the substrate on which the interlayer dielectric layer is formed.

14. The method according to any one of claims 11 to 13, wherein forming the barrier layer specifically comprises: forming the barrier layer by using a non-conductive material; and
the method further comprises: after forming the barrier layer and before forming the etching stop layer, forming a plurality of second contact holes that penetrate the barrier layer, wherein the second contact holes are disposed in correspondence to the first contact holes and communicate with the first contact holes, and the etching rate of the barrier layer is greater than an etching rate of the metal silicide layer under an etching condition of the barrier layer.

15. An electronic device, comprising a circuit board and the chip according to any one of claims 1 to 10, wherein the chip is disposed on the circuit board.
